# EUROPEAN PATENT APPLICATION

(11) **EP 2 447 596 A2**
(43) Date of publication of application: **02.05.2012**
(21) Application number: 11186669.5
(22) Date of filing: 26.10.2011
(51) Int. Cl.: F21K 99/00, H05K 1/11, H05K 1/02, F21Y 101/02

(54) **Light emitting device and illumination device**

(30) Priority: 26.10.2010 JP 2010240190
(71) Applicant: Toshiba Lighting & Technology Corporation, Yokosuka-shi Kanagawa-ken (JP)
(72) Inventor: Betsuda, Nobuhiko, Kanagawa-ken (JP); Matsuda, Shuhei, Kanagawa-ken (JP); Shibusawa, Soichi, Kanagawa-ken (JP); Uemura, Kozo, Kanagawa-ken (JP); Nishimura, Kiyoshi, Kanagawa-ken (JP)
(74) Representative: HOFFMANN EITLE

(57) **Abstract**

According to one embodiment, a light emitting device(1) includes a substrate(2), a lead pattern(4) and a plurality of mounting pads(3), and a plurality of light emitting elements(5). The substrate(2) includes an insulating layer. The lead pattern(4) and the plurality of mounting pads(3) are formed on a surface of the substrate(2). The lead pattern(4) and the plurality of mounting pads(3) are conductive. The plurality of mounting pads(3) are configured not to electrically conduct. The lead pattern(4) is configured to electrically conduct. The plurality of light emitting elements(5) are mounted on the mounting pads(3) and electrically connected to the lead pattern(4).

## Description

### FIELD

Embodiments described herein relate generally to a light emitting device and an illumination device using a light emitting element such as an LED as a light source.

### BACKGROUND

Recently, LEDs have been used as light sources of illumination devices. Such light sources include many bare LED chips disposed on a substrate and mounted to the substrate by electrically connecting the LED chips to a lead pattern by bonding wires. Then, the substrate is multiply included in an LED illumination device by being embedded in a main body made of a metal such as aluminum, etc.

Normally, in such a conventional illumination device, lighting control of the LED is performed by power being supplied by a lighting device connected to an alternating-current power source. Also, the main body made of the metal has a grounding potential by being grounded.

### BRIEF DESCRIPTION OF THE DRAWINGS

FIG. 1 is a plan view illustrating a light emitting device according to an embodiment of the invention;
FIG. 2 is an enlarged plan view illustrating a part of the light emitting device in a state before forming a sealing member;
FIG. 3 is a schematic cross-sectional view illustrating the light emitting device taken along line Y-Y shown in FIG. 2;
FIG. 4 is a plan view illustrating a mounting pad and a lead pattern of the light emitting device;
FIG. 5 is an enlarged plan view illustrating the mounting pad and the lead pattern of the light emitting device;
FIG. 6 is a circuit diagram illustrating a connection state of light emitting elements of the light emitting device; and
FIG. 7 is a circuit diagram illustrating an illumination device according to the embodiment of the invention.

### DETAILED DESCRIPTION

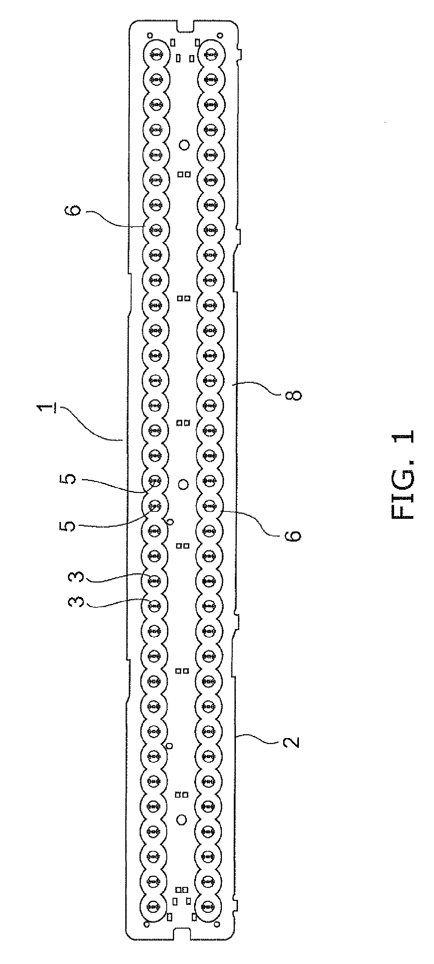

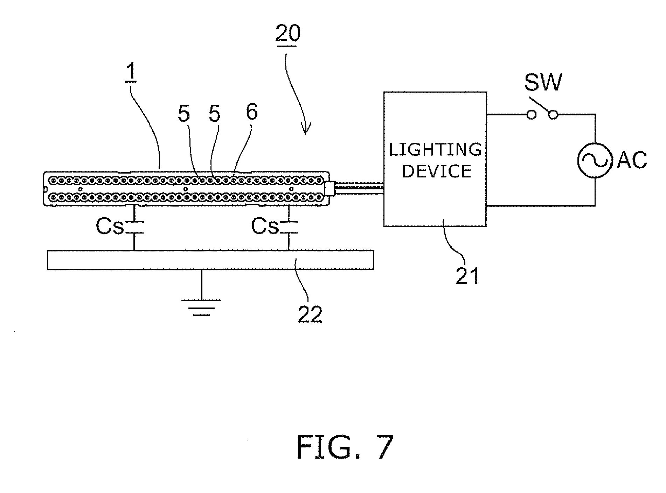

In general, according to one embodiment, a light emitting device includes a substrate, a lead pattern and a plurality of mounting pads, and a plurality of light emitting elements. The substrate includes an insulating layer. The lead pattern and the plurality of mounting pads are formed on a surface of the substrate. The lead pattern and the plurality of mounting pads are conductive. The plurality of mounting pads are configured not to electrically conduct. The lead pattern is configured to electrically conduct. The plurality of light emitting elements are mounted on the mounting pads and electrically connected to the lead pattern. The light emitting device and the illumination device according to an embodiment of the invention will now be described with reference to FIG. 1 to FIG. 7. FIG. 1 to FIG. 6 illustrate the light emitting device; and FIG. 7 illustrates the illumination device. Similar portions in the drawings are marked with like reference numerals, and duplicate descriptions are omitted.

As illustrated in FIG. 1 to FIG. 5, a light emitting device 1 includes a substrate 2, mounting pads 3 and a lead pattern 4 that are formed on a surface of the substrate 2, multiple light emitting elements 5, and a sealing member 6.

At least an upper surface of the substrate 2 is insulative. For example, the substrate 2 is an insulating layer made of an insulating material such as a glass epoxy resin, etc., and is formed in a slender rectangular configuration. The length dimension is about 250 mm to 300 mm; and the width dimension is about 10 mm to 32 mm. It is favorable for the thickness dimension of the substrate 2 to be not less than 0.5 mm and not more than 1.8 mm; and a thickness dimension of about 1 mm is used in this embodiment.

The configuration of the substrate 2 is not limited to a rectangular configuration. A square configuration or a circular configuration may be used. A ceramic material or another synthetic resin material may be used as the material of the substrate 2. To improve the heat dissipation of the light emitting elements 5, a substrate made of a metal may be used as the substrate 2, where a base plate made of a metal material such as aluminum, etc., that has good thermal conductivity and excellent heat dissipation is provided and an insulating layer is stacked on one surface of the base plate.

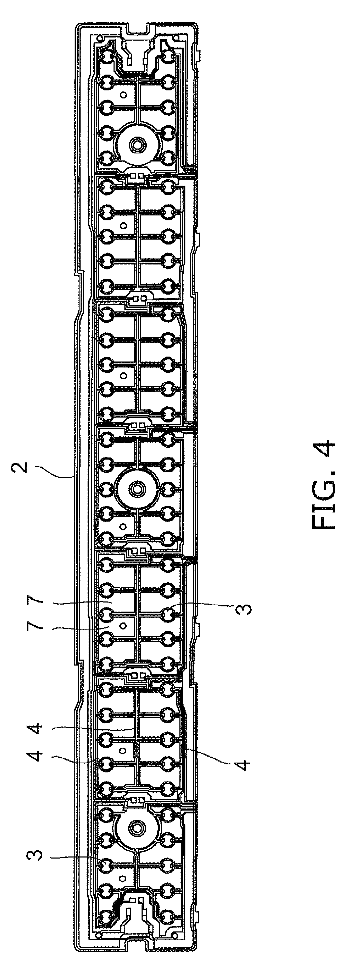

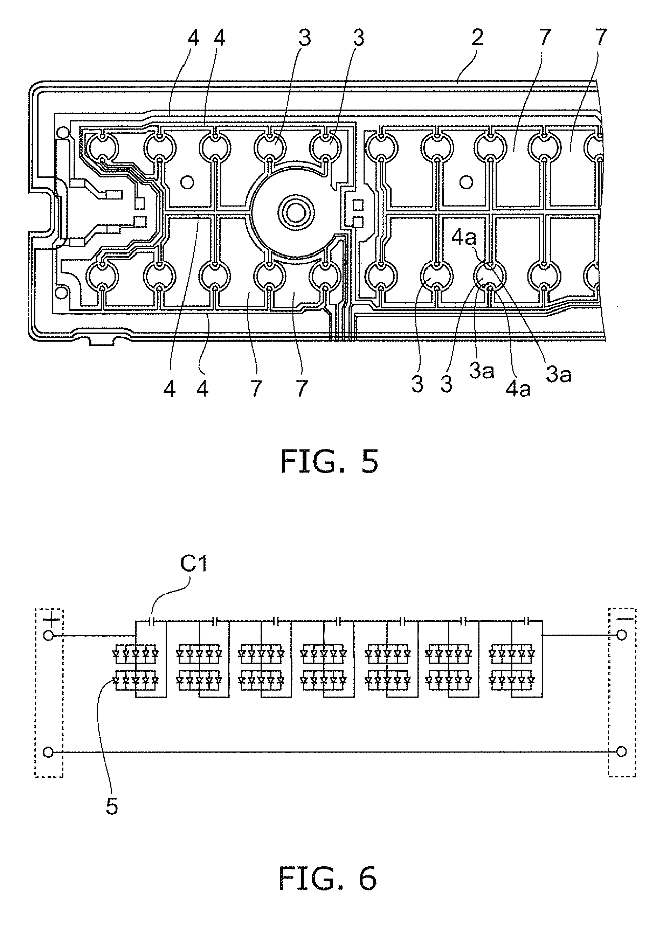

FIG. 4 and FIG. 5 illustrate the mounting pads 3 and the lead pattern 4 formed on the surface of the substrate 2. As in a typical description referring to FIG. 4 and FIG. 5, the mounting pads 3 and the lead pattern 4 are conductive and have a three layer configuration as described below. The layer structure of the mounting pads 3 is the same as the layer structure of the lead pattern 4. In other words, layers that are formed from the same material and have the same thicknesses are stacked in the same order.

The mounting pad 3 is the portion where the light emitting element 5 is mounted; the mounting pad 3 has a substantially circular configuration; and a pair of notches 3a are made in the mounting pad 3 by opposing portions of the circumference (in FIG. 5, the portion on the upper side and the portion on the lower side) being notched in arc configurations. The power supply members 4a extend from the lead pattern 4 and are disposed inside the pair of notches 3a. In other words, the power supply members 4a enter the notches 3a. The notch 3a and the power supply member 4a are insulated from each other by being separated by a prescribed distance.

As illustrated in FIG. 4, the mounting pads 3 are multiply formed in a column along the longitudinal direction of the substrate 2. Specifically, there are two columns along the longitudinal direction of the substrate 2; and one column has thirty-five mounting pads 3 disposed at substantially uniform spacing.

The mounting pad 3 is a nonconducting pad that is conductive but is configured not to electrically conduct and is electrically isolated. The surface of the mounting pad 3 functions as a reflective layer and functions as a heat dissipation layer that dissipates heat generated by the light emitting element 5.

The lead pattern 4 is included in a power supply path, has a pattern of fine leads, and can supply power from a power source side to the light emitting elements 5. As described above, the power supply members 4a, to which the light emitting elements 5 are connected, are provided in the lead pattern 4. A pattern of a metal layer, e.g., a copper foil 7, that dissipates the heat of the substrate 2 is formed over the entire surface of each of the regions substantially surrounded by the mounting pads 3 and the lead pattern 4. The copper foil 7 is insulated from the mounting pads 3 and the lead pattern 4. Thereby, the thermal uniformity of the entire substrate 2 can be increased and the heat dissipation performance can be improved.

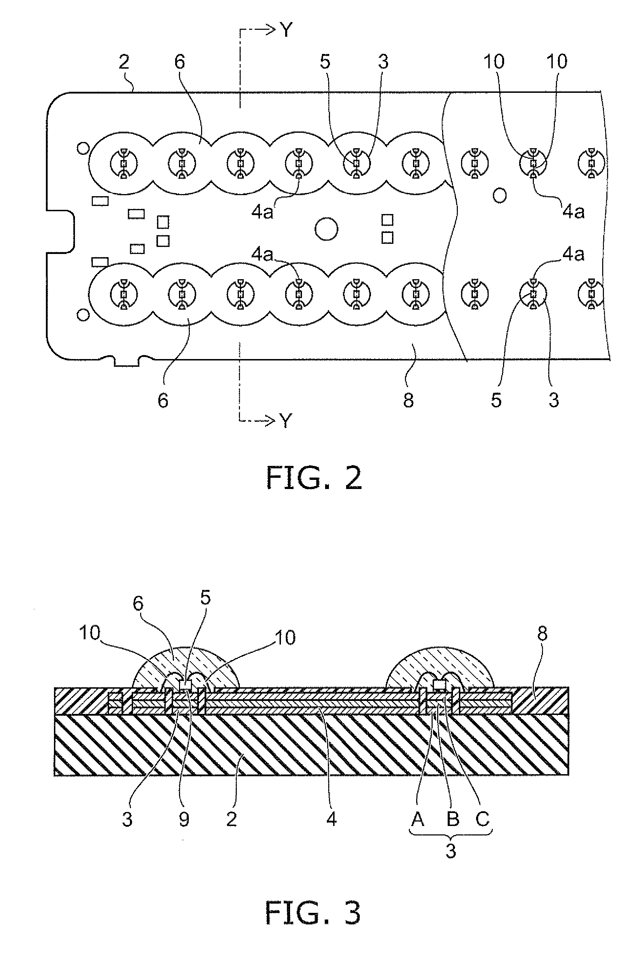

As illustrated in FIG. 3, the mounting pads 3 and the lead pattern 4 have a three layer configuration in which a copper pattern is provided by etching as a first layer A on the surface of the substrate 2. Nickel (Ni) is electroplated as a second layer B on the copper pattern layer; and silver (Ag) is electroplated as a third layer C. Therefore, the third layer C, i.e., the surface layer, is a silver (Ag) plating layer. Thereby, the upper surfaces of the mounting pads 3 and the lead pattern 4 have a metallic luster and a high total luminous reflectance of 90%.

For the electroplating, it is favorable to form the nickel (Ni) of the second layer B with a film thickness not less than 5 µm and the silver (Ag) of the third layer C with a film thickness not less than 1 µm. By such film thickness dimensions, it is possible to realize a uniform film thickness formation and provide a uniform reflectance.

As illustrated in FIG. 1 to FIG. 3, a white resist layer 8 that has a high reflectance is stacked on substantially the entire surface of the surface layer of the substrate 2 except for the regions of the mounting pads 3 used as the mounting regions of the light emitting elements 5, the regions of the power supply members 4a of the lead pattern 4, and the mounting portions of parts.

The multiple light emitting elements 5 are made of bare LED chips. A chip configured to emit blue light, for example, is used as the bare LED chip to emit whitish light from a light emitting unit. The bare LED chips are bonded onto the mounting pads 3 using a silicone resin-type insulative bonding agent 9.

The bare LED chip is, for example, an InGaN-type element formed by stacking a light emitting layer on a transparent sapphire element substrate, where the light emitting layer is formed by sequentially stacking an n-type nitride semiconductor layer, an InGaN light emitting layer, and a p-type nitride semiconductor layer. The electrodes for causing a current to flow in the light emitting layer include a positive-side electrode formed of a p-type electrode pad on the p-type nitride semiconductor layer and a negative-side electrode formed of an n-type electrode pad on the n-type nitride semiconductor layer. These electrodes are electrically connected to the upper surfaces of the power supply members 4a of the lead pattern 4 by bonding wires 10. The bonding wires 10 are made of fine gold (Au) wires and are connected via bumps (not illustrated) having a main component of gold (Au) to increase the mounting strength and reduce damage of the bare LED chips.

The multiple light emitting elements 5 are mounted on the mounting pads 3 in substantially central portions of the substantially circular configurations of the mounting pads 3; and the light emitting elements 5 and the mounting pads 3 are disposed with a one-to-one relationship. Accordingly, two columns of light emitting elements are formed by mounting the light emitting elements 5 on the multiple mounting pads 3 arranged in the longitudinal direction.

Because the power supply members 4a of the lead pattern 4 extend into the notches 3a of the mounting pads 3, it is possible for the bonding wires 10 to be shorter by that amount.

It is favorable for the power supply members 4a to be formed with a surface area in a range of 1 to 2 times the surface area of the upper surface of the bare LED chip. In the case of being less than a factor of 1, there is a possibility that discrepancies may occur during the bonding and during use because the reliability of the bonding of the bonding wires 10 is poor. In the case of being greater than a factor of 2, the surface area of not only the power supply members 4a but also the lead pattern 4 increases as an entirety; and there is a tendency for erroneous lighting of the light emitting elements 5 to occur easily as described below.

Specifically, the dimensions of the upper surface of the bare LED chip are 0.5 mm by 0.3 mm; the surface area of the upper surface of the bare LED chip is 0.15 mm²; and the surface area of the power supply member 4a is 0.25 mm².

For example, the light emitting elements 5 thus disposed are connected from a positive-side power source through the lead pattern 4, through one of the power supply members 4a, and through the bonding wire 10 to the positive-side electrode of the light emitting element 5 and from the negative-side electrode of the light emitting element 5 through the bonding wire 10 to one other of the power supply members 4a; and the light emitting elements 5 are supplied with power by the lead pattern 4. Accordingly, the mounting pads 3 are in a state of being isolated without being electrically connected.

The light emitting elements 5 connected as recited above are in a connection state such as that illustrated in FIG. 6. That is, seven circuits are connected in series; each of the seven circuits includes two parallel circuits connected in series; the condenser C1 for preventing the erroneous lighting of the light emitting elements 5 is connected between two ends of the two parallel circuits; and each of the two parallel circuits includes five of the light emitting elements 5 connected in parallel. In other words, the condenser C1 is connected to two ends of a circuit made of at least one of the light emitting elements 5. The substrate 2 may be electrically connected multiply and continuously; and the number of the substrates 2 used may be appropriately selected.

The sealing member 6 is made of a transparent synthetic resin, e.g., a transparent silicone resin, and contains an appropriate amount of a fluorescer such as YAG:Ce and the like. The sealing member 6 includes multiple protrusion-shaped fluorescer layers; and in this embodiment, the sealing member 6 includes a collection of protrusion-shaped fluorescer layers that respectively cover the individual light emitting element 5. The protrusion-shaped fluorescer layers are formed in hill-shaped configurations with arc-like protruding configurations that are linked to adjacent protrusion-shaped fluorescer layers at the base portions. In other words, the sealing member 6 has a configuration in which the multiple protrusion-shaped fluorescer layers are linked in a column. The configuration of each of the protrusion-shaped fluorescer layers is, for example, a convex lens or a portion of a sphere. Accordingly, the sealing member 6 is formed in multiple columns along the light emitting element columns, that is, is formed in two columns, to cover and seal the light emitting elements 5 and the bonding wires 10.

The fluorescer is excited by light emitted by the light emitting element 5 and radiates light of a color that is different from the color of the light emitted by the light emitting element 5. To emit white light in this embodiment in which the light emitting element 5 emits blue light, a yellow fluorescer, which radiates a yellowish light which is complementary to the blue light, is used as the fluorescer.

The sealing member 6 is formed by being coated onto the light emitting elements 5 and the bonding wires 10 in an uncured state and by subsequently being cured by being thermally cured or by being left for a prescribed amount of time.

Effects of the light emitting device 1 recited above will now be described also with reference to FIG. 7. FIG. 7 is a schematic connection diagram illustrating an illumination device. The illumination device 20 has, for example, a form used as general lighting and includes a lighting device 21, which is connected to a commercial alternating-current power source AC via a power source switch SW, and a main body 22, which contains the light emitting device 1. The lighting device 21 includes, for example, a smoothing condenser connected between the output terminals of a full-wave rectifying circuit and by connecting a direct-current voltage conversion circuit and a current detection unit to the smoothing condenser. Direct-current power is supplied from the lighting device 21 via a connector to the light emitting device 1; and lighting control of the light emitting elements 5 of the light emitting device 1 is performed. The main body 22 is made of a metal that is conductive such as aluminum, etc., and has a grounding potential by being grounded.

When a current is provided to the light emitting device 1, the light emitting elements 5 which are covered with the sealing member 6 simultaneously emit light; and the light emitting device 1 is used as a planar light source to emit white light. Of the light radiated by the light emitting element 5, the light that is emitted toward the substrate 2 side during the light emission is reflected by the surface layer of the mounting pads 3 mainly in the utilization direction of the light. The mounting pads 3 function as heat spreaders to promote the heat dissipation by diffusing the heat emitted by the light emitting elements 5.

In such a case, the light is reflected efficiently with the central portions of the mounting pads 3 as the centers of light emission because the light emitting elements 5 are mounted on substantially the central portions of the substantially circular configurations of the mounting pads 3. Additionally, wasteful regions of the mounting pads 3 can be reduced because it is possible to reduce the surface area of the regions of the mounting pads 3 not utilized for the reflection.

However, there is a possibility that a stray capacitance Cs may occur in the case where the main body 22 is proximal to the lead pattern 4 that connects the light emitting elements 5. For such stray capacitance, the main body 22, which has the grounding potential, forms one electrode; mainly the lead pattern 4 forms one other electrode; and electrostatic coupling occurs via a dielectric between these electrodes. In such a case, the size of the stray capacitance is proportional to the surface area of the electrodes. In the light emitting device 1 as recited above, the mounting pads 3 are nonconducting pads that are conductive but are configured not to electrically conduct and are electrically isolated.

Accordingly, the stray capacitance Cs can be reduced because the surface area of the one other electrode can be reduced because the mounting pads 3 do not form the one other electrode.

Thereby, in the state in which the power source switch SW is off, even in the case where noise is superimposed in the power line, the flow of a micro current as a leak current in the light emitting elements 5 can be suppressed; and as a result, it is possible to avoid the erroneous lighting of the light emitting elements 5.

It may be conceivable for the bonding wires 10 to be connected to the mounting pads 3 to which the light emitting elements 5 are mounted and for the mounting pads 3 to be used also as the lead pattern 4 by being configured to electrically conduct. However, in such a case, if the surface area of the mounting pads 3 is increased to improve the heat dissipation effects and the reflection effects of the light of the light emitting element 5, this acts to accordingly increase the stray capacitance Cs; and there is a possibility that the leak current due to the noise may flow in the light emitting elements 5 and the erroneous lighting of the light emitting elements 5 may occur.

In this embodiment, because the surface area of the mounting pads 3 does not act to increase the stray capacitance Cs even in the case where the surface area of the mounting pads 3 is increased because the mounting pads 3 are nonconducting pads configured not to electrically conduct, the mounting pads 3 can be effectively and practically used; and the erroneous lighting of the light emitting elements 5 can be suppressed while increasing the heat dissipation effects and the reflection effects of the light of the light emitting elements 5 by suppressing the flow of the micro current as the leak current in the light emitting elements 5.

Additionally, it is possible to further increase the effect of suppressing the erroneous lighting of the light emitting elements 5 by the condensers C1 illustrated in FIG. 6.

According to this embodiment as recited above, the erroneous lighting of the light emitting elements 5 can be suppressed by reducing the stray capacitance Cs while effectively and practically using the mounting pads 3.

The invention is not limited to the configurations of the embodiments recited above; and various modifications are possible without departing from the spirit of the invention. For example, illumination appliances, display devices, etc., that are used indoors or outdoors are applicable as the illumination device.

According to the embodiments described above, it is possible to provide a light emitting device and an illumination device that can suppress the erroneous lighting of the light emitting elements while effectively and practically using the mounting pads.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A light emitting device(1), comprising:
a substrate(2) including an insulating layer;
a lead pattern(4) and a plurality of mounting pads(3) formed on a surface of the substrate(2), the lead pattern and the plurality of mounting pads being conductive, the plurality of mounting pads being configured not to electrically conduct, the lead pattern being configured to electrically conduct; and
a plurality of light emitting elements(5) mounted on the mounting pads(3) and electrically connected to the lead pattern(4).

2. The light emitting device(1) according to claim 1, wherein the mounting pad(3) has a substantially circular configuration and the light emitting element(5) is mounted on substantially a central portion of the substantially circular configuration, a reflective layer being formed in a surface of the substantially circular configuration.

3. An illumination device(20), comprising:
a device main body(22), a grounding potential being applied to the device main body, the device main body being conductive;
the light emitting device(1) according to claim 1 or 2 disposed on the device main body(22); and
a lighting device(21) connected to an alternating-current power source, the lighting device being configured to supply power to the light emitting device(1).
